(19) Europäisches Patentamt

European Patent Office

Office européen des brevets

(11) Publication number: **0 605 971 A2**

## EUROPEAN PATENT APPLICATION

(21) Application number: **93310018.2**

(51) Int. Cl.5: **G06F 15/60**

(22) Date of filing: **13.12.93**

(30) Priority: **30.12.92 US 998836**

(43) Date of publication of application:
**13.07.94 Bulletin 94/28**

(84) Designated Contracting States:
**DE FR GB IT**

(71) Applicant: **NATIONAL SEMICONDUCTOR CORPORATION**
**2900 Semiconductor Drive,**
**P.O. Box 58090,**
**M/S 16-135**

**Santa Clara, California 95052-8090(US)**

(72) Inventor: **Yamanouchi, Roy K.**
**1040 Summerdale Drive**
**San Jose, California 95132(US)**

(74) Representative: **Bowles, Sharon Margaret et al**
**BOWLES HORTON**
**Felden House**
**Dower Mews**
**High Street**
**Berkhamsted Hertfordshire HP4 2BL (GB)**

(54) **Structured methodology for designing a dual phase data path.**

(57) A data path design methodology permits the use of a library of high level graphics elements that incorporate precharged bus and dual phase concepts. The graphic elements can be combined to form virtually any desired logic function. The combination of the functional elements is accomplished within the constraints of construction rules that assure the robustness of the design.

FIG. 1

Background of the Invention

1. Field of the Invention

The present invention relates to the design of integrated circuits and, in particular, to a structured methodology for designing a dual phase data path using high level graphic functional elements and a set of rules to govern the interconnectability of the functional elements.

2. Brief Definition of Terms

As used in the discussion that follows:

"data path" refers to a set of physical elements that either store, transfer or logically manipulate data. The data can be of any desired width, e.g., 1, 2, 8 or 16 bits.

"dual phase" refers to data transfers between storage and functional elements on both high and low phases of a clock signal.

3. Discussion of the Prior Art

Data paths are structural elements of a digital logic circuit. They consist of the physical, generic data processing elements (e.g., registers, adders, counters, shifters, comparators) of the logic and the physical links (e.g. busses) between these elements.

Currently, data path circuit design is an ad hoc procedure with individual circuit designers following individual manual design methodologies.

Data path design begins with conceptualization of the functionality to be designed. Typically, a bus is then defined as the basic focal point of the data path. Registers and functional units are then connected to the bus "on-the-fly" to provide the desired functionality. Since the single bus constrains the design to one-to-one transfers between data path elements, it is often necessary to incorporate duplicate functional units and custom connections into the design. This often results in a non-standardized, inefficient physical layout for the data path device.

It would, therefore, be highly desirable to have available a standardized, computer-aided, structured data path design methodology that produces an efficient device layout.

Summary of the Invention

The present invention provides a methodology for designing a data path using a library of high level graphic elements that incorporate two precharged busses and dual phase concepts. The graphic elements can be combined to form virtually any desired logic function. The combination of the graphic elements is accomplished within the constraints of a set of construction rules that ensures the robustness of the design.

A key characteristic of the methodology of the present invention is the relationship of the rigidly-structured precharged busses to the physical memory and functional elements within the graphic elements. Each graphic element includes two precharged busses. These busses are of opposite signal phase type and may be segmented. The structure of each graphic element is created to allow memory and functional element access both to and from both types of busses. The ability of each memory and functional element to access either clock phase allows a set of Figure of Merit (FOM) rules to be implemented. Strobe circuits are also detailed within the FOM rules. The clocking scheme is the critical feature that establishes the robustness of synchronous timing both within the data path and relative to other functional operations within the system of which the data path is a part.

The data path design methodology can be used to quickly specify the data path circuit configuration and then implement a corresponding physical layout based on a set of layout cells that correspond to the graphic elements. The data path rules are then satisfied and timing verification is completed.

The design methodology also provides area savings. First, since operations are performed on more than one bit of data (usually multiples of 8), common control signals (e.g., strobes) can be used. Second, data path elements are placed in regular arrays to achieve very dense layout packing. Third, by using precharged, dual phase, multiplexed busses, a very efficient architecture is provided. In a typical case, if the same data path functions were to be implemented using standard synchronous design techniques, about 2-3 times more chip area would be required and the resulting design would be more complex.

A better understanding of the features and advantages of the present invention will be obtained by reference to the following detailed description and accompanying drawings which set forth an illustrative embodiment in which the principles of the invention are utilized.

Description of the Drawings

Fig. 1 is a flow chart illustrating a data path design sequence in accordance with the present invention.

Fig. 2 is a schematic diagram illustrating a data path designed in accordance with the methodology of the present invention.

Fig. 3 is a timing diagram illustrating six types of signals utilizable in a data path designed in accordance with the methodology of the present invention.

Figs. 4a-4i are schematic diagrams illustrating nine 8-bit register graphic functional elements utilizable in a data path designed in accordance with the methodology of the present invention.

Figs. 5a-5h are schematic diagrams illustrating eight bus driver graphic functional elements utilizable in a data path designed in accordance with the methodology of the present invention.

Figs. 6a-6c are schematic diagrams illustrating three precharge graphic functional elements utilizable in a data path designed in accordance with the methodology of the present invention.

Figs. 7a-7g are schematic diagrams illustrating seven graphic functional elements utilizable in a data path designed in accordance with the methodology of the present invention.

Figs. 8a and 8b are schematic diagrams illustrating two control logic/data bit graphic functional elements utilizable in a data path designed in accordance with the methodology of the present invention.

Figs. 9a-9j are schematic diagrams illustrating ten spacer, extender and special graphic functional elements utilisable in a data path designed in accordance with the methodology of the present invention.

Fig. 10 is a flow chart illustrating a block level timing verification (BLTV) procedure utilizable in a design methodology in accordance with the present invention.

Fig. 11 is a block diagram illustrating the timing calculations for the block level timing verification procedure shown in Fig. 10.

Fig. 12 is a block diagram illustrating a single bit data and strobe/buffer cell array for an 8-bit data path.

Detailed Description of the Invention

A structured dual phase data path design methodology in accordance with the present invention is computer implemented utilizing a design platform that includes three primary components: (1) a library of standard data path graphic functional elements, (2) data path design creation tools (e.g., schematic capture, layout generator, etc.), and (3) data path design verification tools (e.g., block level timing verifier, etc.). Each of these components will be discussed in greater detail below.

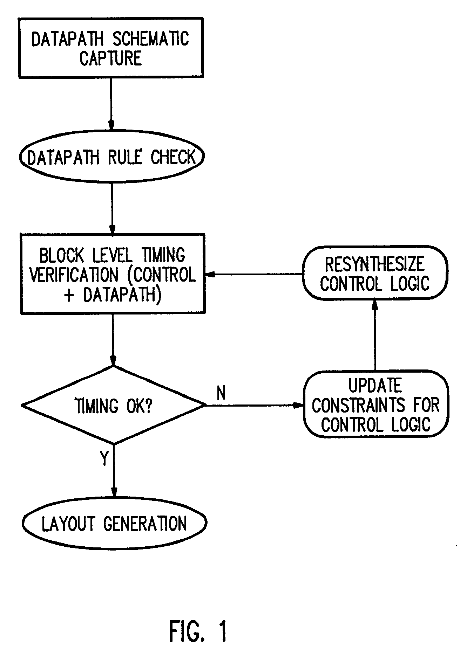

Fig. 1 shows a data path design sequence in accordance with the methodology of the present invention. The data path design is typically done before the control logic for the system of which the data path is a part has been defined, either by flowchart techniques or manually. As shown in Fig. 1, first, the logic designer draws the data path schematic by placing 8-bit graphic functional elements together. This is done in a conventional schematic capture environment; for example, a Cadence schematic capture environment is appropriate. The data path schematic is then checked to satisfy all data path rules for electrical and logical compatibility. If the associated control logic is to be designed with flow chart tools, then a flow chart constraint file is created and the control logic is synthesized. A block level timing verifier (BLTV) procedure is then used to check the timing of all interface signals between the data path and the control logic; also, all propagation delays and setup/hold times are checked. In the event that timing problems are identified, the control logic signals are either speeded up or slowed down. If the control logic was designed manually or by other means, then appropriate steps must be taken to speed up or slow down the signals. The BLTV procedure is then run again; a few iterations may be necessary to insure that all timing is correct. Finally, the data path schematic is converted, almost instantaneously, into a corresponding layout.

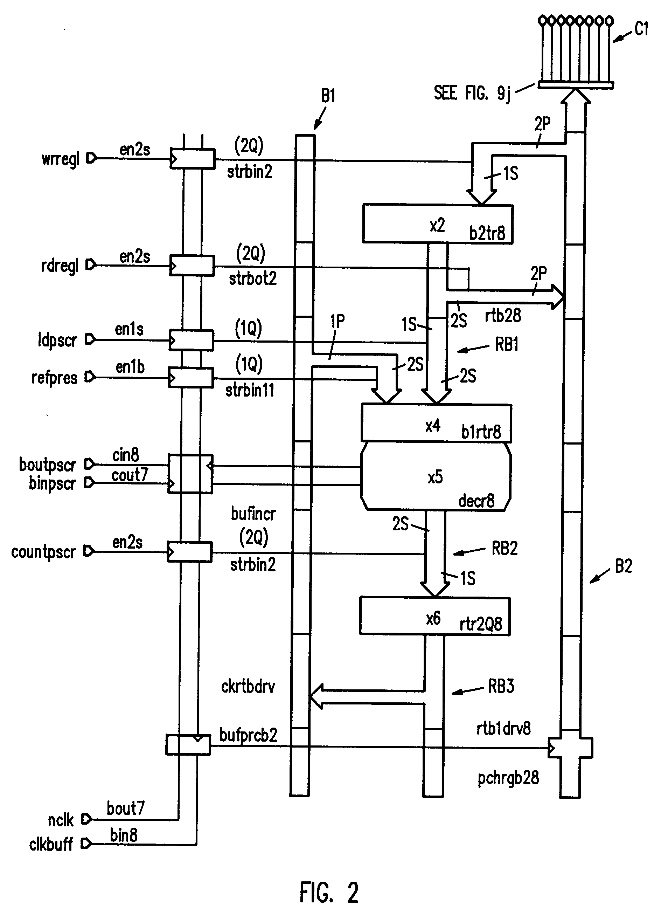

Fig. 2 shows an example data path. The two thin long columns on the right and in the middle of Fig. 2 are the two data busses. The data bus on the right is identified as bus B2; the data bus in the middle is identified as bus B1. Data processing elements such as registers, bus drivers, decrementers, etc. are located between the two busses B1 and B2. In addition, three small busses (RB1, RB2, RB3) are located between buses B1 and B2 and extend from one data processing element to another. These busses are collectively referred to as register busses.

As further shown in Fig. 2, input/output signals on the left of the Fig. 1 data path interface to the associated control logic. The control logic interface signals connect to small boxes that are collectively referred to as strobe/buffer cells. Two clock signals "nclk" and "clkbuff", shown at the bottom left of Fig. 2, provide the clock signals for the data path. As shown at the top right of Fig. 2, bus B2 is brought out on a

EP 0 605 971 A2

connector C1, which is used in connecting the Fig. 2 data path schematic to another data path schematic.

As shown in Fig. 2, bus B1, bus B2 and the register busses RB1, RB2, RB3 have small horizontal lines across them. These lines define the boundaries between graphic functional elements selected from a library of standard 8-bit graphic functional elements stored in the computer's system memory. For example, the "decr8" box and the "bufdecr" box, which are between two such lines, are a part of the same graphic symbol for the decrementer functional element. As shown in Fig. 2, the decrementer symbol also includes the bus B1 and bus B2 columns. Similarly, the "rtr2Q8" box, the "strbin2" box, the register bus RB2 that connects box "decr8" to element rtr2Q8, and bus B1 and bus B2 are all part of another graphic symbol for a register functional element. In accordance with the concepts of the present invention, these individual graphic symbols of the 8-bit graphic functional element files are stacked together in a selected sequence to create a desired data path schematic.

As stated above, the Fig. 2 data path architecture is based on dual phase design. Thus, on every phase of the clock signal clkbuff, some data processing activity is possible.

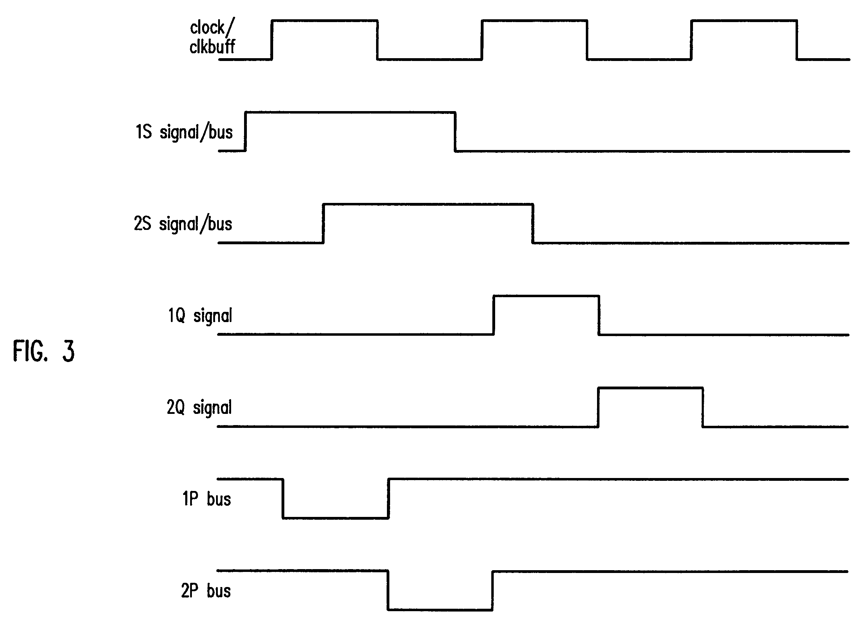

As shown in Fig. 3, the following six types of signals maybe utilized in creating a data path in accordance with the concepts of the present invention:

1. 1S - these signals change only when the clock is low; hence, they are stable during clock high.

2. 2S - these signals change only when the clock is high; hence, they are stable during clock low.

3. 1Q - these signals are derived from the clock high pulse; hence, they are a pulse type delayed from the clock high pulse.

4. 2Q - these signals are derived from the clock low pulse; hence, they are a pulse type delayed from the clock low pulse.

5. 1P - this type of bus is precharged during clock low and evaluated during clock high.

6. 2P - this type of bus is precharged during clock high and evaluated during clock low.

The data path schematic shown in Fig. 2 also shows the signal type of each signal and each bus. A bus has all of its constituent signals of the same type. Bus B1 is always 1S or 1P type; bus B2 is always 2S or 2P type. Register busses can be either 1S or 2S type.

In the disclosed data path design methodology, there are 39 8-bit graphic functional elements individual in the standard graphic functional elements library. These graphic functional elements can be classified into the following six groups: registers (9 types), bus drivers (8 types), precharge elements (4 types), functional elements (7 types), control logic to data bit elements (2 types), and spacers and extenders (10 types).

8-bit Register Elements

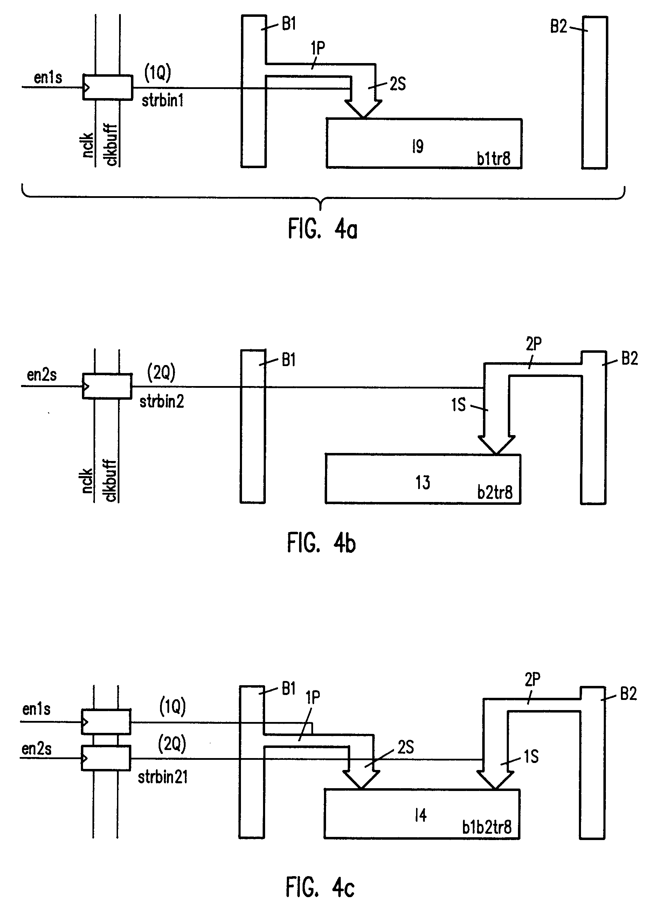

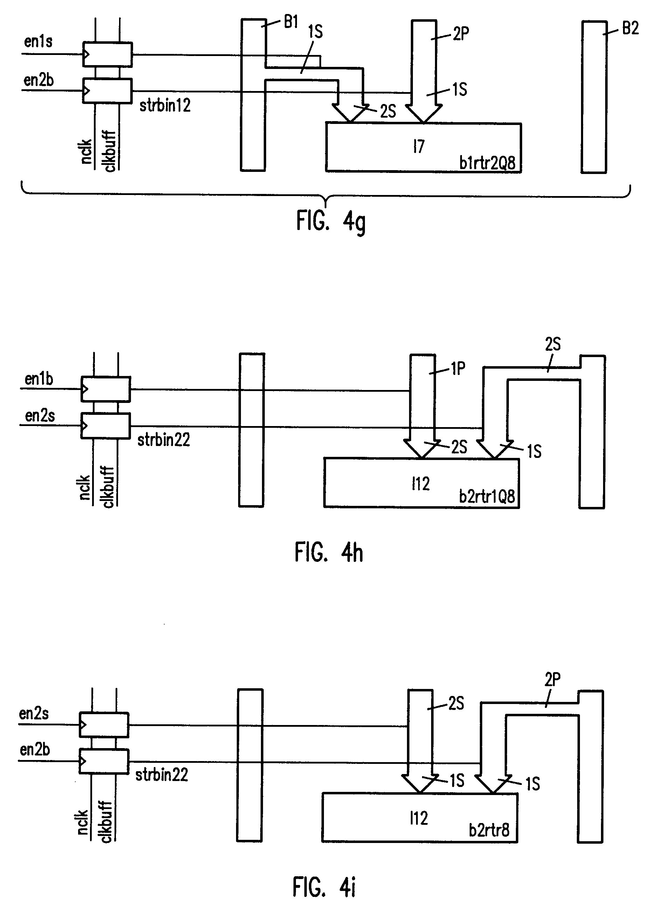

The nine types of register graphic functional elements included in the functional elements library, and shown in Figs. 4a-4i, include memory cells. The register elements differ in how data is input to them. Normally, the input data to the register elements comes from either a bus, another register, or a functional element. The output of the register drives either a bus driver, a functional element, another register or a combination of the above. The nclk and clkbuff clocks generate 1Q and 2Q type strobe signals to time the loading of data into the register elements. Further information regarding each of the register elements is provided below (see Figs. 4a-4i):

1. b1tr8 Bus1 to register (8-bit): When signal en1s is high, the contents of bus B1 are transferred to register 19 at the clkbuff rising edge (Fig. 4a).

2. b2tr8 Bus2 to register (8-bit): When signal en2s is high, the contents of bus B2 are transferred to register 13 at the clkbuff falling edge (Fig. 4b).

3. b1b2tr8 Bus1 or Bus2 to register (8-bit): When signal en1s is high, the contents of bus B1 are transferred to register 14 at the clkbuff rising edge. When signal en2s is high, the contents of bus B2 are transferred to register 14 at the clkbuff falling edge (Fig. 4c).

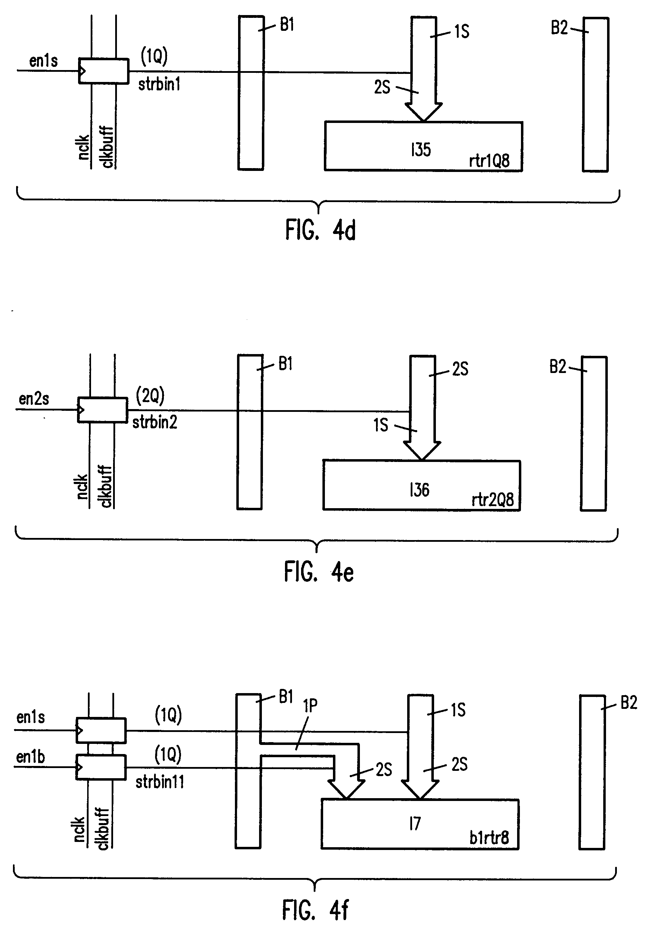

4. rtr1Q8 Register to register (8-bit) with 1Q strobe: When signal en1s is high, the contents of the register above are transferred to register 135 at the clkbuff rising edge (which generates a 1Q strobe) (Fig. 4d).

5. rtr2Q8 Register to register (8-bit) with 2Q strobe: When signal en2s is high, the contents of the register above are transferred to register 136 at the clkbuff falling edge (which generates a 2Q strobe) (Fig. 4e).

6. b1rtr8 Bus1 or register to register (8-bit): When signal en1s is high, the contents of bus B1 are transferred to register 17 at the clkbuff rising edge. When signal en1b is high, the contents of the register above are transferred to register 17 at the clkbuff rising edge (reg to reg transfer is by 1Q strobe) (Fig. 4f).

7. b1rtr2Q8 Bus1 or register to register (8-bit): When signal en1s is high, the contents of bus B1 are transferred to register 17 at the clkbuff rising edge. When signal en2b is high, the contents of the register above are transferred to register 17 at the clkbuff falling edge (reg to reg transfer is by 2Q strobe) (Fig.

4

4g).

8. b2rtr1Q8 Bus2 or register to register (8-bit): When signal en2s is high, the contents of bus B2 are transferred to register 112 at the clkbuff falling edge. When signal en1b is high, the contents of register above are transferred to register 112 at the clkbuff rising edge (reg to reg transfer is by 1Q strobe) (Fig. 4h).

9. b2rtr8 Bus2 or register to register (8-bit): When signal en2s is high, the contents of bus B2 are transferred to register 112 at the clkbuff falling edge. When signal en2b is high, the contents of the register above are transferred to register 112 at the clkbuff falling edge (reg to reg transfer is by 2Q strobe) (Fig. 4i).

### Bus Drivers

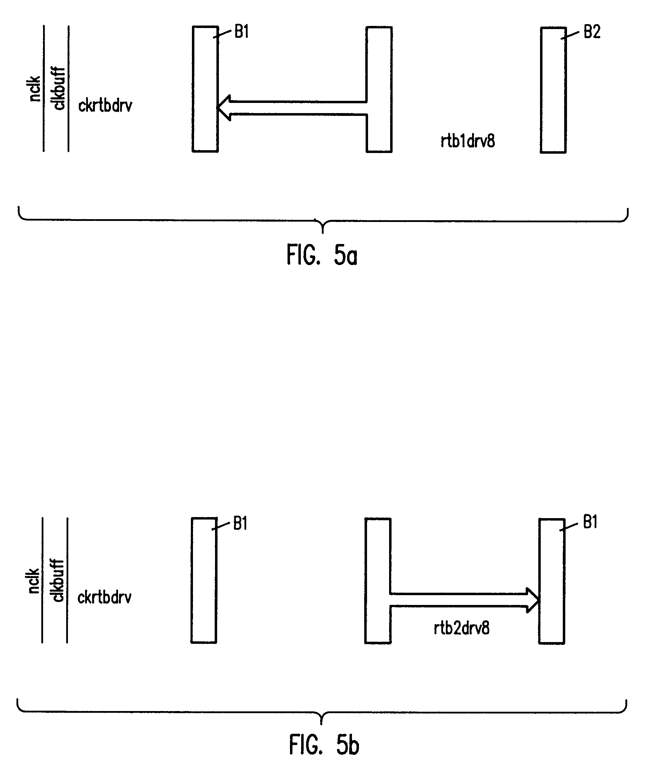

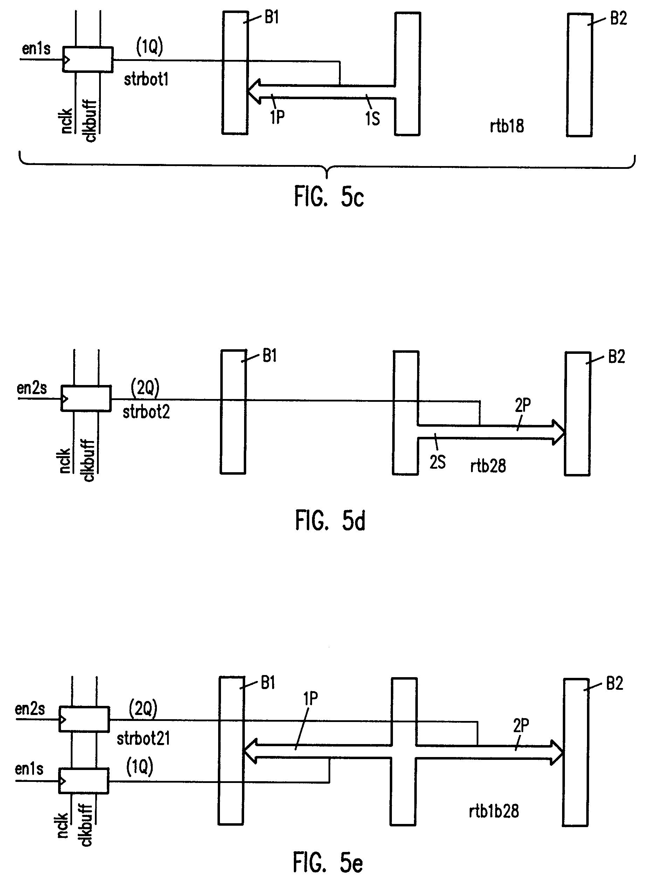

The eight types of bus driver graphic elements included in the graphic functional elements library are shown in Figs. 5a-5h. Normally, the input to a bus driver comes from either a register or a functional element. The bus drivers drive static or precharged busses. The bus drivers also extend their input signal to the element below (which may or may not use it). The nclk and clkbuff clock signals generate 1Q and 2Q type strobes to time the pull down of precharged bus drivers. Further information regarding each of the bus driver elements is provided below (see Figs. 5a-5h):

1. rtb1drv8 Register to Bus1 driver (8-bit): The contents of the register above are continuously transferred to the static bus B1 of 1S type (Fig. 5a).

2. rtb2drv8 Register to Bus2 driver (8-bit): The contents of the register above are continuously transferred to the static bus B2 of 2S type (Fig. 5b).

3. rtb18 Register to Bus2 (8-bit): When signal en1s is high, the contents of the register above are transferred to the precharged bus B1 of 1P type at the clkbuff rising edge (Fig. 5c).

4. rtb28 Rester to Bus2 (8-bit): When signal en2s is high, the contents of the register above are transferred to the precharged busB2 of 2P type at the clkbuff falling edge (Fig. 5d).

5. rtb1b28 Register to Bus1 or Bus2 (8-bit): When signal en1s is high, the contents of the register above are transferred to the precharged bus B1 of 1P type at the clkbuff rising edge. When signal en2s is high, the contents of the register above are transferred to the precharged bus B2 of 2P type at the clkbuff falling edge (Fig. 5e).

The following bus driver graphic elements are different in that they do not transfer a register output onto the bus. Instead, they transfer signals from control logic onto the bus:

6. b1zero8 Bus1 to zero pulldown (8-bit): When signed en1s is high, precharged bus B1 of 1P type is pulled down to zero at the clkbuff rising edge (Fig. 5f).

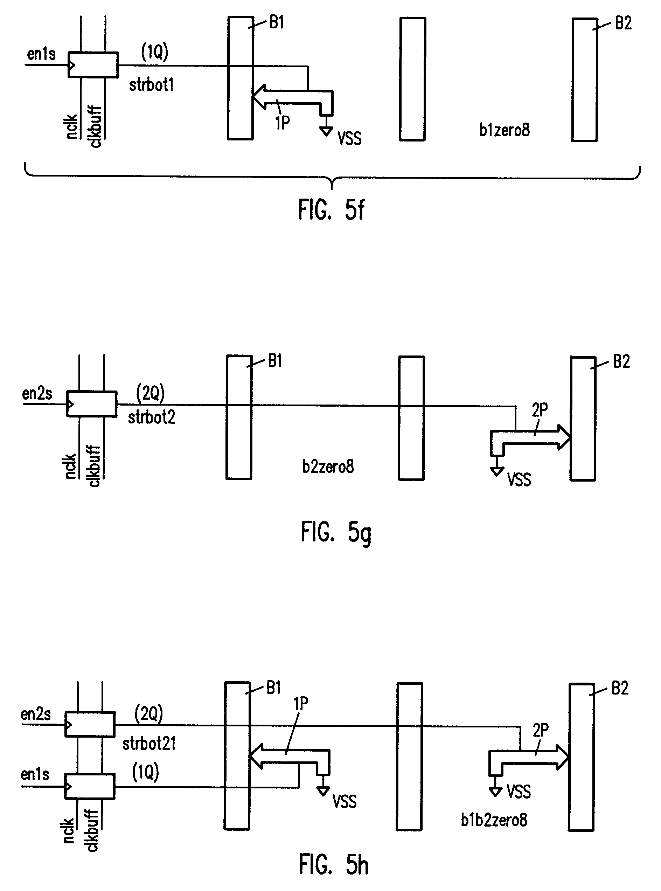

7. b2zero8 Bus2 to zero pulldown (8-bit): When signal en2s is high, precharged bus B2 of 2P type is pulled down to zero at the clkbuff falling edge (Fig. 5g).

8. b1b2zero8Bus1 or Bus2 to zero pulldown (8-bit): When signal en1s is high, precharged bus B1 of 1P type is pulled down to zero at the clkbuff rising edge. When signal en2s is high, precharged bus B2 of 2P type is pulled down to zero at the clkbuff falling edge (Fig. 5h).

### Precharge Elements

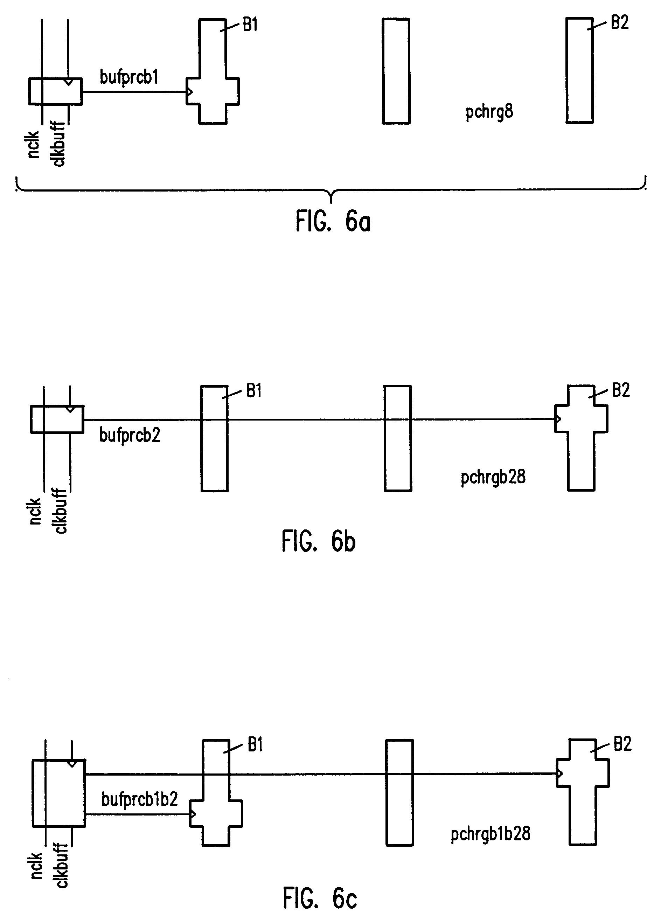

The four types of precharge graphic elements included in the graphic functional elements library are as follows (see Figs. 6a-6c):

1. pchrg8 Precharge Bus1 (8-bit): This element precharges bus B1 of 1P type during clkbuff low (Fig. 6a).

2. pchrgb28 Precharge Bus2 (8-bit): This element precharges bus B2 of 2P type during clkbuff high (Fig. 6b).

3. pchrgb1b28 Precharge Bus1 and Bus2 (8-bit): This element precharges bus B1 of 1P type during clkbuff low and bus B2 of 2P type during clkbuff high (Fig. 6c).

4. b1prchcap8 Capacitor element for Bus1: This element precharges bus B1 when the sum of inputs and outputs connected to the bus (excluding the precharge element and the capacitor element itself) is less than 7 (not shown).

### Functional Elements

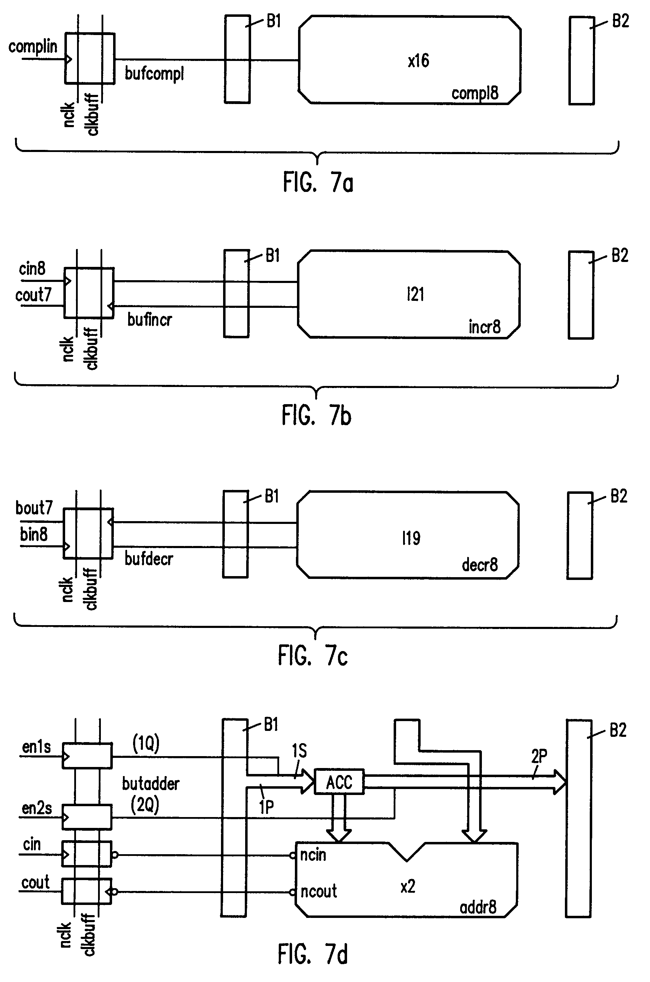

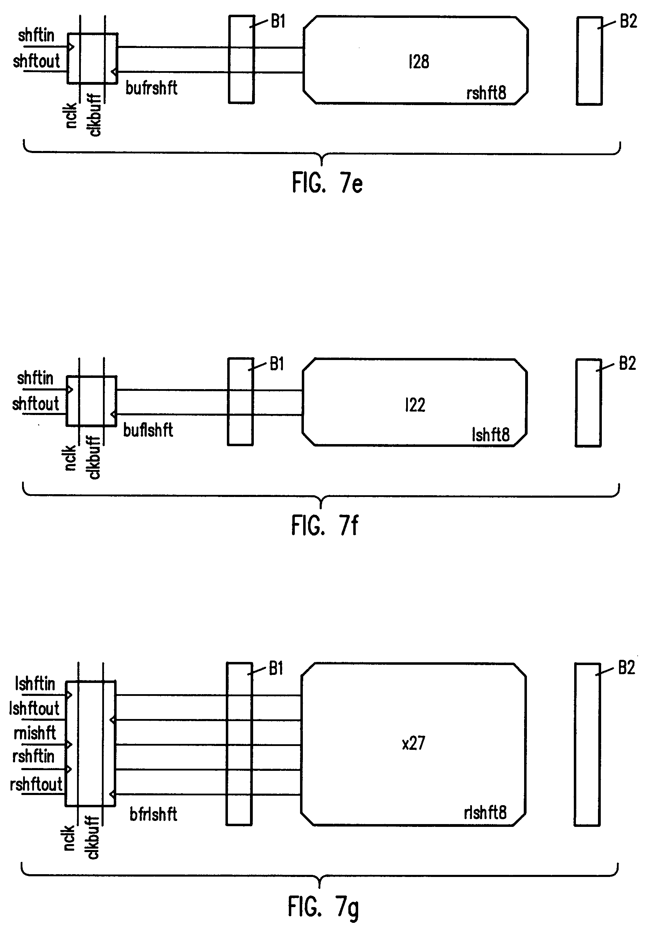

Seven graphics elements included in the graphic functional elements library, shown in Figs. 7a-7g, provide the arithmetic/logic functions of the data path design. These elements accept data both from the registers above them and from the control logic, e.g., carry in. The output data is delivered at the bottom of the element and can drive either another register, a bus driver, another functional element, or a combination of the above. Except for the adder, which has a built-in register, none of these elements uses either bus B1 or bus B2; they merely extend these busses to elements below them. Further information regarding each of these elements is provided below (see Figs. 7a-7g):

1. compl8 Complementer (8-bit): When signal complin is high, the 8-bit data input from above is complemented and then passed to the element below. When signal complin is low, the data from above is passed to the element below as such (Fig. 7a).

2. incr8 Incrementer (8-bit): Signal cin0 is added to the 8-bit data input from above and the 8-bit sum is delivered to the element below. The cout7 signal is the resultant carry from the most significant bit (msb) (Fig. 7b).

3. decr8 Decrementer (8-bit): bin0 is subtracted from the 8-bit data input from above and the 8-bit result is delivered to the element below. The bout7 signal is the resultant borrow from the msb (Fig. 7c).

4. addr8 Adder (8-bit): The adder adds two 8-bit data bytes and signal cin. One of the operand bytes comes from the element above the adder, while the other comes from the built-in register (Accumulator) in the adder. The Accumulator can be loaded from bus B1. The accumulator contents can be read on 2P type bus B2. The 8-bit sum is delivered to the element below the adder. The cout signal is the resultant carry from the msb (Fig. 7d).

5. rshft8 Right-shift (8-bit): This element shifts right by one bit the data it receives from the element above it. The least significant bit (lsb) (bit0) of the data input from above is available on shftout and shiftin becomes the msb (bit7) of the data output by the shifter (Fig. 7e).

6. lshft8 Left-shift (8-bit): This element shifts left by one bit the data it receives from the element above it. The msb (bit7) of the data input from above is available on shftout and shiftin becomes the lsb (bit0) of the data output by the shifter (Fig. 7g).

7. rlshft8 Rightleft-shift (8-bit): When signal rnlsht is high, this element acts as a right shifter; the lsb (bit0) of the data input from above is available on shtout and shiftin becomes the msb (bit7) of the data output by the shifter. When signal rnlshft is low, it acts as a left shifter; the msb (bit7) of the data input from above is available on shftout and shiftin becomes the lsb (bit0) of the data output by the shifter (Fig. 7g).

### Control Logic to Data Bit Elements

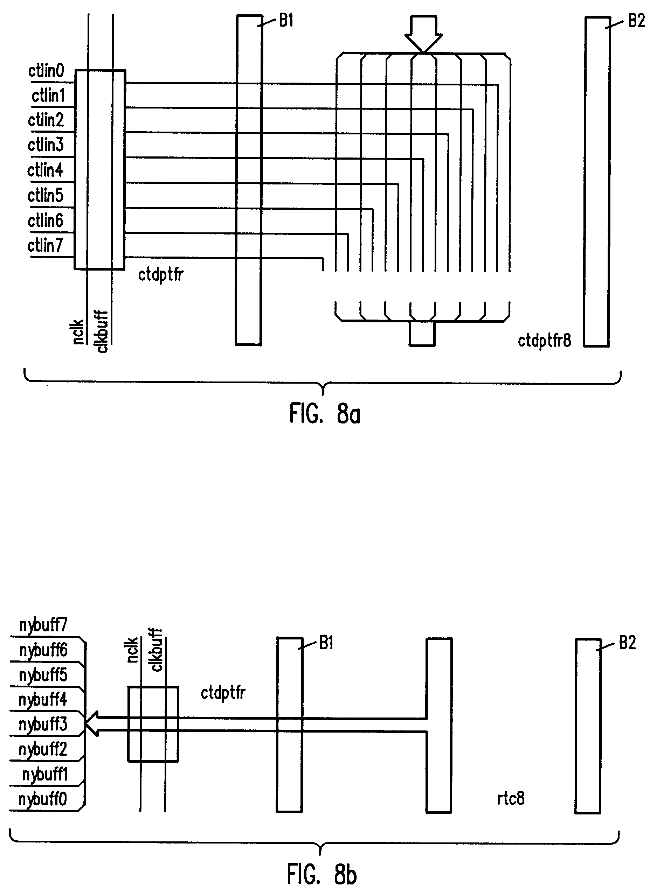

The graphic functional elements library includes two special graphics elements, shown in Figs. 8a and 8b, that allow the control logic to directly drive/receive one or more data bit lines in the datapath:

1. ctdptfr8 Control to datapath transfer (8-bit): This is a 8-bit holding cell, i.e., it is a framework cell that allows eight single bit cells to be placed in it. These single bit cells can be of two types: Ctlsel (selects the control logic input to drive the corresponding data bit line) and Dpsel (selects the datapath input to drive the corresponding data bit line) (Fig. 8a).

2. rtc8 Register to control logic (8-bit): This element brings out the eight data bits inside the datapath for use by control logic (Fig. 8b).

### Spacers and Extenders

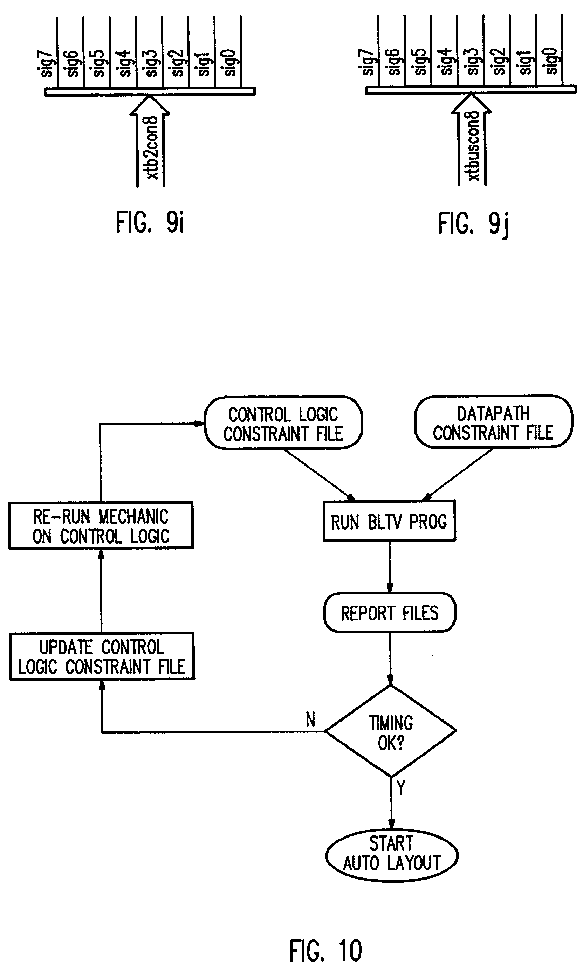

The spacers and extender graphics elements included in the graphic functional elements library, and shown in Figs. 9a-9j, have no logic inside them. They consist of purely interconnect to selectively extend busses B1 and/or B2 and the register bus. All of these elements extend the clkbuff and nclk clock signals:

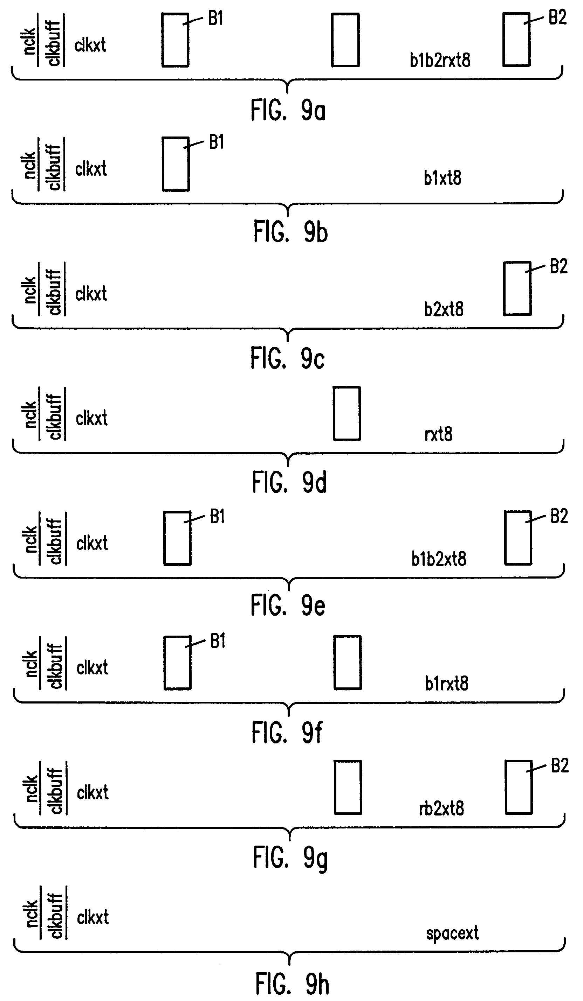

1. b1b2rxt8 Bus1, Bus2, and Register bus extender (8 bit) (Fig. 9a).
2. b1xt8 Bus1 extender (8 bit) (Fig. 9b).
3. b2xt8 Bus2 extender (8 bit) (Fig. 9c).
4. rxt8 Register bus extender (8 bit) (Fig. 9d).
5. b1b2xt8 Bus1 and Bus2 extender (8 bit) (Fig. 9e).
6. b1rxt8 Bus1 and Register bus extender (8 bit) (Fig. 9f).
7. rb2xt8 Bus2 and Register bus extender (8 bit) (Fig. 9g).
8. spacext Spacer, no busses extended (8 bit) (Fig. 9h).

The two remaining elements in the graphic elements library, shown in Figs. 9i and 9j, are special because they have only symbols and no corresponding layout. They are just to provide interconnectivity of busses B1 and B2 across different schematic pages:

9. xtbuscon8 Extender/connector for bus B1 (8 bit)

10. xtbus2con8 Extender/connector for bus B2 (8 bit)

As stated above, a datapath schematic like the one shown in Fig. 2 is created by stacking the 8-bit graphic elements from the graphic functional elements library on top of one another. In general, if a signal must go from element 1 (e.g., b2tr8 register) to element 2 (e.g., rtb28 bus driver), then the element 1 (register) graphics symbol is stacked on top of the element 2 (bus driver) symbol. The busses can be driven by any element in the stack and extend through all the elements except the spacer/extenders. The bus on the left, i.e. bus B1, is always 1S or 1P, while the bus on the right, i.e. bus B2, is always 2S or 2P. The graphics element stacking arrangement is copied identically onto layout, which is automatically generated by butting pre-layed out elements, as explained in greater detail below.

The datapath schematic is created by placing the 8-bit element symbols in a schematic template. The interface connections to the control logic, the clock signals and any bus connectors are connected to appropriate pins and then labelled. The completed schematic is then extracted and an appropriate fabrication process is selected.

To ensure correctness of logic and timing, a set of data path rules must be satisfied. These include electrical rules and interconnectivity rules for the datapath elements and guarantee electrical and logic correctness.

Circuit block design using the data path methods disclosed herein is very well suited (but not limited) to designs that also use the control logic flowchart methodology disclosed in co-pending and commonly assigned U.S. Pat. Appln. Serial No. 546,376 filed June 28, 1990, by R. Tamanachi et al. for STRUCTURED LOGIC DESIGN METHOD USING FIGURES OF MERIT AND A FLOWCHART METHODOLOGY (which application is hereby incorporated by reference to provide additional background information regarding the present invention). This is because the flowchart control logic design methodology described in the referenced application uses the same signal types as those used for the herein-described data path design methodology. Thus, using flowchart methods for the control logic design ensures compatibility of signal types with the data path design and allows easy use of timing verification tools for analysis of complete circuit blocks. However, the data path methodology described herein is not limited to use with flowcharted control logic blocks. It can be used in any circuit block with a proper understanding of its interconnectivity and timing.

Electrical Rules

A few simple electrical rules must be followed to ensure compatibility among data path elements and with the associated control logic. These rules are based on FOM techniques disclosed in the above-referenced flowchart application and classify signals into the six types shown in Fig. 3. The required compatibilities between different signal types are listed below:

1. 1P and 2P signal types are used only for precharged busses. 1P signals are evaluated while clkbuff is high and precharged when clkbuff is low. 2P signals are evaluated while clkbuff is low and precharged when clkbuff is high.

2. 1Q and 2Q signal types are used only as strobes to time data movement.

3. 1Q strobes are generated by gating 1S signals with clkbuff.

4. 2Q strobes are generated by gating 2S signals with nclk.

5. 1S and 2S signal types are generic; they can be used for static data busses, register busses, and all datapath control logic signals.

6. 1P signals must be latched by 1Q strobes into a register before use. The register output is then 2S type, i.e., stable during clkbuff low.

7. 2P signals must be latched by 2Q strobes into a register before use. The register output is then 1S type, i.e., stable during clkbuff high.

8. 1S must be strobed by 1Q strobes for transfer to another register or a 1P bus. The register output is then 2S type.

9. 2S signals must be strobed by 2Q strobes for transfer to another register or a 2P bus. The register output is then 1S type.

10. When the sum of inputs and outputs on a precharged bus is less than 7, a capacitor element must be connected to that bus. This is to ensure there is enough bus capacitance to overwrite a register input.

Data path element interconnection rules are based on the above-listed electrical rules and loading considerations.

Bus Rules

1. Busses are either static 1S/2S, or precharged 1P/2P.
2. All data transfers to a bus are mutually exclusive.
3. All data transfers from a bus are mutually exclusive.
4. Data transfer from a bus can only be to a register.
5. Only a bus driver or precharge element can drive a bus.

Bus Driver Rules

1. Static bus drivers do not have strobes to time data transfer.
2. Precharged bus drivers have strobes to time data transfer.
3. Bus drivers get data from registers, or functional elements, or the ctdptfr8 (control logic to datapath) graphics element.

Exception: the b1zero8, b2zero8, and b1b2zero8 graphics elements do not receive data from any of the elements mentioned above. These bus drivers pull down the bus to zero when enabled by control logic, thus accomplishing a control logic to data bus transfer.

Register Rules

1. All registers have strobes for loading input data. The source of data may be a bus, or another register, or a functional resource, or ctdptfr8 (control logic to datapath) graphics element.
2. A register can drive a bus driver, another register, a functional element, or the rtc8 (register to control) graphics element.
3. A register can drive any combination of elements mentioned in item 2, as permitted by interconnection of symbols.

Rule 3. means that the symbols of different elements prevent illegal connections, e.g., connection of a register to two functional elements. This is because the register bus doesn't run through functional elements and through registers themselves. (As discussed below, there are other rules which may exclude some interconnections of registers to other elements).

4. Registers must be written to and read from on opposite phases.

Exception: A register can be read and written on the same phase if the read/write are from the same bus and are mutually exclusive. This implies a register with an input from any bus can drive the same bus if the read and write from the common bus are mutually exclusive.

5. A register with two input sources must have both of them of similar type, i.e., 1S & 1S/1P or 2S & 25/2P.

Exception1: A register may have two different types of input sources if both are busses and the register output drives only one or both of those two busses. Again, the read/write from any bus must be mutually exclusive.

Exception2: A register may also have two different types of input sources if one is a bus and the register output drives only that bus. Again the read/write from the bus must be mutually exclusive.

Functional Element Rules

1. Data inputs to a functional element are static and can come from a register, another functional element or control logic.
2. Functional elements are fully combinational (except the adder which has a built in register). Hence, the signal inputs and outputs are of same type.
3. A functional element can drive only one bus. The control inputs to the functional element must be consistent with the bus it drives, i.e., when driving bus B1, the control inputs must be 1S; when driving bus B2, the control inputs must be 2S.
4. When the data input to the functional element is always 1S (or always 2S) then the functional element can drive bus B1 (or bus B2), or a register, or another functional element, or the ctdptfr8 (control logic to datapath) graphics element in any combination as permitted by the interconnection of symbols.

Exception: When the data input to the functional element is always 1S (or always 2S), then the functional element can drive bus B2 (or bus B1) only if the register driving the functional element has input from bus B2 (or bus B1) only. The write to the register and the read from the functional element on the common bus must be mutually exclusive.

5. When the data input to the functional element can be 1S at times and 2S at other times, then the functional element can drive only a bus and no other elements.

a. When the register driving the functional element has inputs from bus B1 and bus B2, then the functional element can drive either (but only one) of the busses B1 and B2. The write to the register and the read from the function element on the common bus must be mutually exclusive.

b. When the register driving the functional element has inputs from bus B1 (or bus B2) and a register bus, then the functional element can drive only bus B1 (or bus B2). The write to the register and the read from the functional element on the common bus must be mutually exclusive.

Control Logic - Datapath Interface Rules

1. All interface signals between the control logic and datapath must be 1S or 2S type.

2. The interface signals from control logic to datapath must connect to

c. enable input on the strobe cells of a register or bus driver element

d. control input of a buffer cell, e.g., cin for adder, lshftin of left-shifter etc.

e. register bus via ctdptfr8 element

3. The interface signals from datapath to control logic must originate from

a. control output of a buffer cell, e.g., cout for adder, lshftout of left-shifter etc.

b. register bus via rtc8 element

4. The data busses 1P/1S and 2P/2S cannot connect to the control logic.

Block level timing verification (BLTV) is done collectively on all control logic and data path blocks within a "super-block" (a "super-block" is a circuit block containing a combination of data path and control logic flowchart elements, e.g. timer, UART, etc.) The timing verifier checks delays on all signal paths. The delays are calculated for the user-specified fabrication process and then evaluated to meet the operating frequency specified by the user. Signals that do not meet timing requirements are flagged and need to be speeded up. Usually the signal paths inside the control logic are speeded up because data path element delays are fixed. Rarely, when a signal cannot be speeded up enough, a change in the data path and control logic architecture may become necessary. Since control logic and data path layout is automatic, time is spent only on defining the new architecture and not on physical design.

The BLTV procedure is illustrated in Fig. 10.

Constraint Files

A constraint file is needed for each block of control logic and data path to run the BLTV procedure. The constraint files for the control logic are automatically generated during control logic synthesis. The data path constraint file must be generated by hand.

As shown in Table I below, the constraint file for a block lists each input/output signal, the signal type, the signal timing requirements, and the signal loading inside the block. The following is a brief description of each of the fields in this file:

1. Signal Class: The timing class/type of the signal: 1S, 2S, clock, etc.

2. Signal Type: input, output or I/O

3. Eff. Width: Effective N Channel width of device which drives the port, (outputs only).

4. Cport: Capacitance seen looking into the port (pin).

5. Allowed Time (for control logic only): This is an initial guess value for input arrival times and output delay times.

a. For inputs, the allowed time is defined by the block which produces it and the routing delay.

b. For outputs, the allowed time is defined by the requirements of the block receiving the signal and the routing delay.

For 1S type inputs and outputs, allowed time is with respect to clock falling edge. For 2S type inputs and outputs, it is with respect to clock rising edge. Table I shows that, for the block ctrl16, input signal s4lout of 2S type is allowed 25ns max (after the clock falling edge) to become stable. Also shown is that b2tos output signal of 2S type is driven by a driver of $W_n$ = 4.5u and is allowed 32ns (after the clock rising edge) to become stable.

6. Actual Time:

a. For inputs, the actual maximum setup time needed for this signal within the block.

b. For outputs, the actual maximum propagation delay seen by this signal within the block.

Note: For inputs Actual > Allowed.

For outputs Actual < Allowed.

7. Cout: Capacitance that this port is expected to drive. This value is used to size the output driver for new blocks or to verify loading on existing blocks. (outputs only).

8. Max Stages: The number of inversions the signal experiences inside this block before being latched. This value is only required by blocks which are in the process of being sized. (inputs and outputs)

9. Mealy: Specifies if the signal is a mealy signal or not. Inputs are specified as mealy if they drive an output via only logic and no latching.

Note: For signals which are mealy, Allowed and Actual times will be maximum propagation time through the block, not just to a latch.

10. Reset Value: The binary value this signal will be while the block is in reset.

11. +/-: Specifies whether the signal is positive or negative logic; (active high or active low).

In addition to the above fields, for each signal there are three global fields for the complete block. They are:

1. max_node_delay: Max slope of rise or fall times for all gates within this block.

2. max_frequency: Max frequency these timing characteristics are assuming

3. process: Process on which the above timing characteristics are based

## TABLE I

```
#
# Timing and Signal Type Characterization File
# (Alias "Constraint File")
#
BlockName: ctrl16
# Date: Fri Aug 28 10:03:14 1992
#
#
# The following file defines the timing and signal type characteristics for
# the block "BlockName". In the case of an existing block, this data is used
# to define the constraints on new blocks it will interface with. In the case
# of new blocks, this data will be used during synthesize and sizing.
#
# Not all fields are required for every block. If a field is not being used,
# there must be a "-" used in place of the value.
#
# This file format can also be used to define the timing and signal type
# characteristics of sub-blocks. This is required when a new block consists
# of multiple machines which each need to be synthesized.
#
# Enter the information in the table below. Fields are separated by tabs or
# blank characters.
#
# Start TimingConstraints:
#
#------------------------------------------------------------------------
#
```

| # Name | Signal Class | Signal Type | Eff. Width (u) | Cport (pf) | Allowed Time (ns) | Actual Time (ns) | Cout (pf) | Max Invs | Mealy | Reset Value | +/- |
|--------|--------------|-------------|----------------|------------|-------------------|------------------|-----------|----------|-------|-------------|-----|
| s4lout | 1S | input | - | 0.601 | 25.000 | 28.153 | - | 5 | N | 0 | + |
| nmar0x | 2S | input | - | 0.617 | 10.000 | 21.564 | - | 7 | Y | 0 | + |
| pow | 2S | input | - | 0.838 | 0.000 | 21.423 | - | 7 | Y | 1 | + |
| cout | 1S | input | - | 0.459 | 20.000 | 24.096 | - | 6 | Y | 1 | - |
| phi | clock | input | - | 0.887 | 0.000 | 40.000 | - | 0 | N | 0 | + |
| b4tor4 | 1S | output | 4.500 | 0.085 | 32.000 | 22.913 | 0.174 | 6 | N | 1 | - |
| b2tos2 | 2S | output | 4.500 | 0.085 | 32.000 | 32.764 | 0.215 | 6 | Y | 1 | - |
| s2stob3 | 1S | I/O | 4.500 | 0.085 | 32.000 | 28.856 | 0.178 | 7 | N | 0 | + |

```
#
#-------------------------------
# Values used by FOM sizing program
#-------------------------------
max_node_delay 4.0
max_frequency 12.5
process cs150
#
# End TimingConstraints
```

The constraint file shown in Table I is for the ctrl16 block. The first signal name is s4lout. It is a 1S type input signal to the block. The port capacitance (capacitive load on the signal inside the ctrl16 block) is 0.601 pf. The signal is allowed 25ns after clkbuff falling edge (1S type) to become stable. The BLTV found that the signal actually could take up to 28.153ns after the clkbuff rising edge to become stable. Inside the block, there are five gates in the longest signal propagation path before being an input to a latch. The signal is not a mealy input. The signal is an active high type. The column for actual timing shows that BLTV found the signal will be present 28.153ns before the rising clkbuff edge.

The maximum rise/fall time for all signals in the ctrl16 block is 4ns. This means that the slowest a gate will ever be is 4ns (the fastest a gate will ever be is 2ns for cs150). The maximum operating freq of the block is 12.5 Mhz which makes a clock phase = 40ns.

Report Files

The results of the BLTV run are reported in two files: blrv.rpt and bltv__lng.rpt. Table II

## TABLE II

```
#-------------------
# Block Level Timing Check
# Condensed Report
#-------------------
# Design: multdiva
# Date: Fri Aug 14 16:40:11 1992
# Process: cs150
# Freq: 12.50
#
# Clock half cycle = 40.00
#
# NET delay margin
#-------------------
x3cout15          -15.990
x3s4lout           -5.805
x3div              -3.746
x3mult             -3.693
x2sub              -3.366
x6cout              0.495
x2s2lin             1.073
x6powbuf            2.717
x3s2rout            3.628
```

shows a condensed report file. It shows that signals x3cout15-x2sub failed and x6cout-x3s2rout passed.

Table III shows the format for the long report generated by the BLTV procedure. The long report is for the multdiva block which has (sub)blocks ctr116, dpath, interface, loop8, mlsc, etc. The first net or signal reported is xs4lout. This signal failed the propagation delay timing requirements by 5.81ns. The signal is connected to two ports (pins) named s4lout. These two ports are in the dpath and ctr116 (sub)blocks. The BLTV algorithm estimated 85ff of routing capacitance as the signal went from the dpath (sub)block to the ctrl16 (sub)block. The signal is of 1S type (in both (sub)blocks). The signal is driven by a 4.5u driver size (size of N ch) in the dpath block. A total load of 60ff was initially specified on this signal by the logic designer in the constraint file for the dpath block. A load of 601ff was specified in the constraint file for the ctrl16 block by the logic designer (see constraint file for ctrl16 block).

## TABLE III

```
#------------------------
# Block Level Timing Check
#------------------------
# Design: multdiva
# Date: Fri Aug 14 16:40:11 1992
# Process: cs150
# Freq: 12.50
#
# Clock half cycle = 40.00
#
NET:x3s4lout    FAILED
ports:2    routing cap:85.00    delay margin:-5.81    type check:
#------------------------------------------------------------------------
```

| portname | inst | blktype | st | i/o | size | load | delay | setup |
|---|---|---|---|---|---|---|---|---|
| s4lout | x3 | dpath | 1S | OUTPUT | 4.50 | 60.00 | 32.00 | 0.00 |
| s4lout | x2 | ctrl16 | 1S | INPUT | 0.00 | 601 | 0.00 | 28.15 |

```
#
NET:x6powbuf   PASSED
ports:4    routing cap:225.00    delay margin:2.72    type check:
```

| portname | inst | blktype | st | i/o | size | load | delay | setup |
|---|---|---|---|---|---|---|---|---|
| pow | x2 | ctrl16 | 2S | INPUT | 0.00 | 838 | 0.00 | 21.42 |
| pow | x4 | interface | 2S | INPUT | 0.00 | 43.68 | 0.00 | 15.67 |
| pow | x5 | loop8 | 2S | INPUT | 0.00 | 146.56 | 0.00 | 3.02 |
| powbuf | x6 | misc | 2S | OUTPUT | 18.80 | 85.00 | 20.00 | 0.00 |

```
#
NET:x2b4tor4    PASSED
ports:2    routing cap:85.00    delay margin:11.09    type check:
```

| portname | inst | blktype | st | i/o | size | load | delay | setup |
|---|---|---|---|---|---|---|---|---|
| b4tor4 | x2 | ctrl16 | 1S | OUTPUT | 4.50 | 85.32 | 23.11 | 0.00 |
| b4tor4 | x3 | dpath | 1S | INPUT | 0.00 | 24.00 | 0.00 | 5.00 |

```
#
```

The delay calculations are done as follows:

1. $T_{out} = PC*C_{port}*W_n/L_n$; $C_{port}$, $W_n$ (eff. width) are from dpath constraint file
2. $T_{rout} = PC*C_{rout}*W_n/L_n$; $C_{rout}$ is estimated = 85ff by BLTV based on fanout
3. $T_{input} = PC*C_{port}*W_n/L_n$; $C_{port}$ is from ctrl16 constraint file

Then the total path delay is calculated by $T_{path} = T_{output} + T_{rout} + T_{input}$. This delay must be less than one clock phase (40ns in this case).

As stated above, the datapath constraints files are created manually. A blank template of file shown in Table I is used and appropriate fields are filled in with the help of Table IV. Table IV lists all of the 8-bit graphic functional elements and the capacitance (cs150) present on each input and output signal. The output signals also have the driver sizes listed. The format of each entry in Table IV is $C_{port}/W_n$ or simply $C_{port}$ e.g., rtc8 has entry 55/3 under the column nybuff0-nybuff7. This means that, for all the signals nybuff0, nybuff1, ... nybuff7, the total capacitance inside the element ($C_{port}$) on the signal is 55ff. Also, the output driver has Nch 3u wide (cs150). For signals that are inputs, only $C_{port}$ is listed. Table IV allows a user to fill out the Name, Signal type, Eff. width and $C_{port}$ columns in the constraint file. The Signal class column is filled out by looking at the data path schematic. Signals that are always a fixed signal type, e.g. en1s, are listed as 1S type on the symbols. Signals that can have either 1S or 2S type, e.g. cin, are filled in by looking at the particular design itself.

The actual time column is filled in from Table V. The max_frequency field in the constraint file will update these times to actual time upon running the BLTV procedure.

The data path layout is automatically generated from the schematic. There exists a one-to-one correspondence between data path standard element schematics and standard layout cells. The data path layout is then generated by looking at the schematic and stacking layout cells in the same order as schematic symbols.

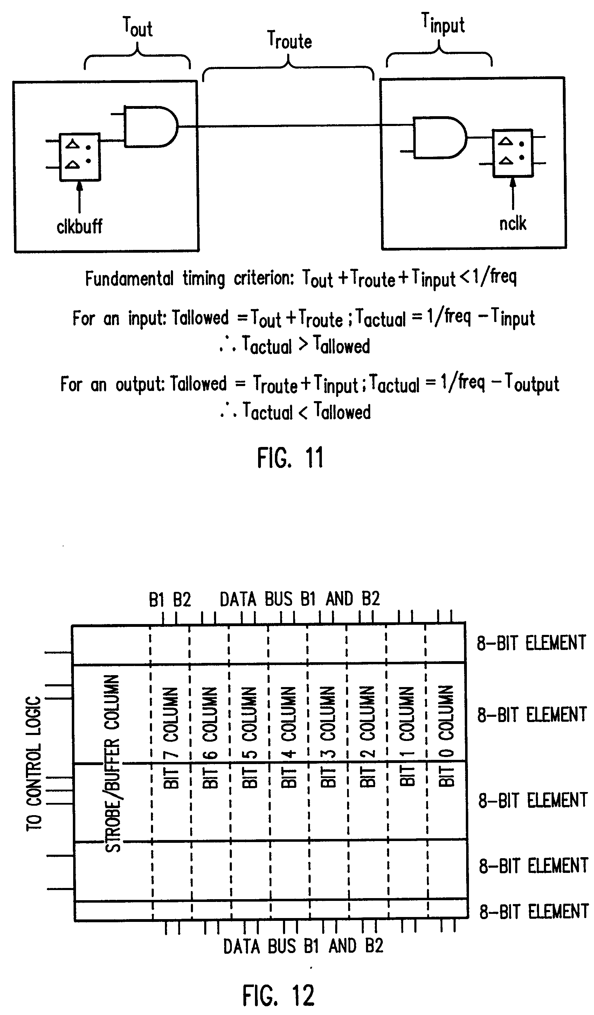

While there is a standard data path cell library, additional custom cells may be created. The data path cell library contains two types of cells; single-bit-data cells and strobe/buffer cells. The type types of cells are physically arrayed together to create n-bit elements. The n-bit elements are then physically arrayed to create the data path block, as shown in Fig. 11.

From the data path schematic, an ascii text array is manually generated. Table VI shows the codes for each data path single bit cell. These codes are entered in to the ascii file, shown in Table VII. Table VII shows ascii text file for the example datapath shown in Fig. 12. The letter codes are in the same spatial arrangement as the datapath symbols themselves. The strobe/buffer cells are defined at the bottom in a separate plane. The Structure Compiler program from Cadence looks at the ascii text file and generates the layout array.

The final step is to blockize the data path block layed out above. This is done by defining the pins (ports) on the layout for the busses and the control logic interface signals. These pins must be defined for use by auto route at the next higher level. After defining the pins lvs and drc are run to finish blockizing.

It should be understood that various alternatives to the embodiment of the invention described herein may be employed in practicing the invention. It is intended that the following claims define the scope of the invention and that methods within the scope of these claims and their equivalents be covered thereby.

TABLE IV

| | Cell Name | CS200(x,y) * | Nclk | Clkbuff | ClkbuffP(1) | * en1s | en2s | en1b | emb2 | cdin0-7 | comp | cin | bin | shftin | lshftin | rshftin | rlshft | * aybuff0 - aybuff7 | cout | bout | lshftout | rshftout |
|---|---|---|---|---|---|---|---|---|---|---|---|---|---|---|---|---|---|---|---|---|---|---|
| Registers | b1tr8 | 614x42.5 | * 20 | 30 | 293 | * 24 | | | | | | | | | | | | * | | | | |
| | b2tr8 | 614x42.5 | * 49 | 38 | 357 | * | 65 | | | | | | | | | | | * | | | | |
| | b1b2tr8 | 614x53 | * 65 | 59 | 293/357 | * 33 | 77 | | | | | | | | | | | * | | | | |
| | rtr1q8 | 614x42.5 | * 20 | 30 | 293 | * 24 | | | | | | | | | | | | * | | | | |
| | rtr2q8 | 614x42.5 | * 49 | 38 | 357 | * | 65 | | | | | | | | | | | * | | | | |
| | b1rtr8 | 614x53 | * 30 | 54 | 293/357 | * 52 | | 30 | | | | | | | | | | * | | | | |
| | b1rtr2q8 | 614x53 | * 65 | 59 | 293/357 | * 33 | 77 | | | | | | | | | | | * | | | | |
| | b2rtr1q8 | 614x53 | * 65 | 59 | 293/357 | * 33 | 77 | | | | | | | | | | | * | | | | |
| | b2rtr8 | 614x53 | * 180 | 62 | 293/357 | * | 125 | | 114 | | | | | | | | | * | | | | |
| Bus Drivers | rtb1drv8 | 614x17 | * 3 | 3 | | * | | | | | | | | | | | | * | | | | |
| | rtb2drv8 | 614x17 | * 3 | 3 | | * | | | | | | | | | | | | * | | | | |
| | rtb18 | 614x27 | * 18 | 35 | 360 | * 28 | | | | | | | | | | | | * | | | | |
| | rtb28 | 614x22 | * 56 | 23 | 175 | * | 55 | | | | | | | | | | | * | | | | |
| | rtb1b28 | 614x37 | * 54 | 61 | 360/175 | * 35 | 47 | | | | | | | | | | | * | | | | |
| | b1zero8 | 614x27 | * 18 | 35 | 360 | * 28 | | | | | | | | | | | | * | | | | |
| | b2zero8 | 614x22 | * 56 | 23 | 175 | * | 55 | | | | | | | | | | | * | | | | |
| | b1b2zero8 | 614x37 | * 54 | 61 | 360/175 | * 35 | 47 | | | | | | | | | | | * | | | | |
| Register-Control | rtc8 | 614x60.5 | * 9 | 9 | | * | | | | | | | | | | | | * 55/3 | | | | |
| | cldptr8 | 614x60.5 | * 9 | 9 | | * | | | 40 | | | | | | | | | * | | | | |
| Precharge | pchrg8 | 614x37.5 | * 10 | 50 | | * | | | | | | | | | | | | * | | | | |
| | pchrgb28 | 614x35 | * 10 | 75 | | * | | | | | | | | | | | | * | | | | |
| | pchrgb1b2 | 614x62.5 | * 20 | 85 | | * | | | | | | | | | | | | * | | | | |
| Functional Elements | comp8 | 614x59.5 | * 9 | 9 | | * | | | | | 50 | | | | | | | * | | | | |
| | incr8 | 614x65 | * 9 | 9 | | * | | | | | | 50 | | | | | | * | 60/4.5 | | | |
| | decr8 | 614x61 | * 9 | 9 | | * | | | | | | | 50 | | | | | * | | 60/4.5 | | |
| | addr8 | 614x263 | * 25 | 25 | | * | | | | | | | 60 | | | | | * | 60/4.5 | 60/4.5 | | |
| | lshft8 | 614x15 | * 9 | 9 | | * | | | | | | | | 50 | | | | * | | | 60/4.5 | |
| | rshft8 | 614x15 | * 9 | 9 | | * | | | | | | | | | 50 | | | * | | | | 60/4.5 |
| | rlshft8 | 614x64.5 | * 9 | 9 | | * | | | | | | | | | | 50 | 50 | 80 * | | | 60/4.5 | 60/4.5 |
| Spacers & Extenders | b1xt8 | 614x3 | rtx8 | 614x3 | | spacext | 614x3 | | | | | | | | | | | * | | | | |
| | b2xt8 | 614x3 | b1rtx8 | 614x3 | | | | | | | | | | | | | | * | | | | |
| | b1b2xt8 | 614x3 | rb2xt8 | 614x3 | | | | | | | | | | | | | | * | | | | |
| | | | b1b2rtx8 | 614x3 | | | | | | | | | | | | | | * | | | | |

(1) ClkbuffP is the extra capacitance when a strobe is enabled. This capacitance also results in extra delay even during inactive time. Please see me for more info.
* denotes estimated (will be updated after LPE extraction)

Arvind Chopra
X 13218

TABLE V

propagation delays (ns)

| | Cell Name | CS200(x,y) | *en/clb | clb-Reqout | Bus-Reqout* | en/clb | clb-Bus | Reqout-Bus | Dp-ctl | Ctl-Dp* | clb-bus high* | clb/in/reqout | reqout-comport | cfin-comport | cin0/bin0/reqout | cin0/bin0-cout7/bout7 | cin0/bin0-nsum7 | reqout-nsum7 | cfin-shftin/reqout | reqout-shftout | cfin-shftout |
|---|---|---|---|---|---|---|---|---|---|---|---|---|---|---|---|---|---|---|---|---|---|
| registers | b1tr8 | 614x42.5 | * | | | * | | | * | * | | | | | | | | | | | |
| | b2tr8 | 614x42.5 | * | | | * | | | * | * | | | | | | | | | | | |
| | b1b2tr8 | 614x53 | * 5 | 9 | 5 | * | | | * | * | | | | | | | | | | | |
| | rtr1q8 | 614x42.5 | * | | | * | | | * | * | | | | | | | | | | | |
| | rtr2q8 | 614x42.5 | * | | | * | | | * | * | | | | | | | | | | | |
| | b1rtr8 | 614x53 | * | | | * | | | * | * | | | | | | | | | | | |
| | b1rtr2q8 | 614x53 | * | | | * | | | * | * | | | | | | | | | | | |
| | b2rtr1q8 | 614x53 | * | | | * | | | * | * | | | | | | | | | | | |
| | b2rtr8 | 614x53 | * | | | * | | | * | * | | | | | | | | | | | |
| bus drivers | rfb1drv8 | 614x17 | * | | | * | N/A | N/A | 6 | * | | * | | | | | | | | | |
| | rfb2drv8 | 614x17 | * | | | * | N/A | N/A | (4 i/ps, 1 o/p on bus)* | * | | * | | | | | | | | | |
| | rfb18 | 614x27 | * | | | * | | | * | * | | * | | | | | | | | | |
| | rfb28 | 614x22 | * | | | * | (8 i/p, 8 o/ps on bus) | | * | * | | * | | | | | | | | | |
| | rfb1b28 | 614x37 | * | | | * | 5 | 9.5 | 5.5 * | * | | * | | | | | | | | | |
| | b1zero8 | 614x27 | * | | | * | | | N/A * | * | | * | | | | | | | | | |
| | b2zero8 | 614x22 | * | | | * | (8 i/p, 8 o/ps on bus) | | N/A * | * | | * | | | | | | | | | |
| | b1b2zero8 | 614x37 | * | | | * | | 9.5 | N/A * | * | | * | | | | | | | | | |
| register-control | rlc8 | 614x60.5 | * | | | * | | | * | 2 | N/A * | * | | | | | | | | | |
| | cldpctrl8 | 614x60.5 | * | | | * | | | * | N/A | 2 * | * | | | | | | | | | |
| precharge | pchrg8 | 614x37.5 | * | | | * | | | * | * | 11.25 * | | | | | | | | | | |
| | pchrgb28 | 614x35 | * | | | * | | | * | * | (8 i/ps, 8 o/ps on bus) | * | | | | | | | | | |
| | pchrgb1b2 | 614x62.5 | * | | | * | | | * | * | * | | | | | | | | | | |
| functional elements | comp8 | 614x59.5 | * | | | * | | | * | * | * | 5 | 5 | 6 | | | | | | | |
| | incr8 | 614x65 | * | | | * | | | * | * | * | | | | | | | | | | |
| | dec8 | 614x61 | * | | | * | | | * | * | * | | | | 5 | 18 | 20 | 22 | | | |
| | add8 | 614x263 | * | | | * | | | * | * | * | | | | 5 | 18 | 20 | 22 | | | |
| | | | * | | | * | | | * | * | * | | | | 5 | 13 | 15 | 17 | | | |
| | lshft8 | 614x15 | * | | | * | | | * | * | * | | | | | | | | 1 | 1 | 4 |
| | rshft8 | 614x15 | * | | | * | | | * | * | * | | | | | | | | 1 | 1 | 4 |
| | rlshft8 | 614x64.5 | * | | | * | | | * | * | * | | | | | | | 5 | 7 | 8 | |

| spacers & extenders | b1x8 | 614x3 | | rx8 | 614x3 | | b1b2rx8 | 614x3 |
|---|---|---|---|---|---|---|---|---|
| | b2x8 | 614x3 | | b1rx8 | 614x3 | | spacext | 614x3 |
| | b1b2x8 | 614x3 | | rb2x8 | 614x3 | | | |

(1) Clkbuff to Nclk delay is assumed = 3ns
(2) x-y means prop delay from x=vcc/2 to y=vcc/2; vcc=4v, slow process, 125deg
(3) x/y means setup time for x before y edge

Arvind Chopra
X1-3218

TABLE VI

```
/********************************************************************
* Module:  sc.il                                                   *
*                                                                  *
* Purpose: Add default properties to array plane.                  *
*                                                                  *
* Design Flow:                                                     *
*                                                                  *
*==================================================================*
* Modification Log:                                                *
*----------+------+----------------------------------------------*
* Date     | Who  | Purpose for Change                            *
*----------+------+----------------------------------------------*
* Jun 1992 |GWW   | Original Code                                 *
*----------+------+----------------------------------------------*
* 7/20/92  |GWW   | Add types j,k,l                               *
*----------+------+----------------------------------------------*
* 7/27/92  |GWW   | Chg rtbldrvr to rtbldrv, swap k<->j types,add m to y  *
*----------+------+----------------------------------------------*
********************************************************************/
procedure( sc()
    prog( (planeName perName orientPattern)
  makeForm( "sc:"
                list('planeName "plane name" "string"  "test1")
                list('orientPattern "orientation" "string"  "2 1 R0 MX")
                list('cancel "Cancel?" "yesOrNo" no)
            )
      if( (cancel == yes) then
                return()
            )
        property(planeName "name" planeName)
        property(planeName "personality" planeName)
        property(planeName "type" "HETEROGENEOUS")
        property(planeName "set" "")
        property(planeName "map" "")
        property(planeName "masters" "\
A:b1tr layout;\
B:b2tr layout;\
E:rtb2 layout;\
G:b2zero layout;\
H:rtc layout;\
J:dpsel layout;\
K:pchrgb1 layout;\
L:pchrgb2 layout;\
M:pchrgb1b2 layout;\
N:decre layout;\
O:decro layout;\
P:strbin11 layout;\
Q:b1rtr layout;\
R:strbin1 layout;\
S:strbin2 layout;\
T:strbin21 layout;\
U:strbot1 layout;\
V:strbot2 layout;\
W:strbot21 layout;\
X:bufprcb1 layout;\
Y:bufprcb2 layout;\
Z:bufprcb1b2 layout;\
a:buffdecr layout;\
b:bufrshft layout;\
c:ctdptfr layout;\
d:b2xt layout;\
e:clkconxt layout;\
f:b2rtr layout;\
h:rtbldrv layout;\
g:strbin22 layout;\
i:clkrtbdrv layout;\
```

17

```
k:decbpe layout;\
j:decbpo layout;\
l:bufdecbyp layout;\
m:clkprchcap layout;\
n:blprchcap layout;\
o:bufrlshft layout;\
p:rlshfte layout;\
q:rlshfto layout;\
r:bufcmpzro layout;\
s:complzero layout;\
t:bufaddr layout;\
u:addre layout;\
v:addro layout;\
w:blzero layout;\
x:strbin2 layout;\
y:rtr layout;\
z:blfftr layout;\
")
        property(planeName "orientation pattern" orientPattern)
)
)
```

<u>TABLE VI</u>
(continued)

TABLE VII

```
.plane p1
BBBBBBBB
EEEEEEEE
QQQQQQQQ
.plane p2
ONONONON
.plane p3
yyyyyyyy
hhhhhhhh
LLLLLLLL
.plane p4
S
V
P
a
S
i
Y
```

**Claims**

1. A structured method of designing an integrated circuit data path, the method comprising:

defining a function elements library that includes a plurality of functional element files, each of the functional element files defining a corresponding functional data path element and a graphic symbol identifying said functional data path element;

defining a layout library that includes a plurality of layout files, each of the layout files defining a corresponding integrated circuit layout cell, there being one-to-one correspondence between the functional element files and the layout files;

defining a set of data path rules for governing the combination of graphic symbols;

combining selected graphic symbols to define a specific data path schematic diagram;

verifying that the specific data path schematic diagram complies with the set of data path rules; and

utilizing the layout files corresponding to the selected graphic symbols to define an integrated circuit layout for the specific data path schematic diagram.

2. A structured method of designing a dual phase, integrated circuit data path, the method comprising:

defining a plurality of graphic circuit schematic elements, each graphic circuit schematic element representing a corresponding data path circuit element that includes a first precharged data bus of a first signal phase type, a second precharged data bus of a second signal phase type, and a functional circuit element connected to the first or to the second precharged data bus;

defining a plurality of layout files, each of the layout files determining a corresponding integrated circuit layout cell such that there is one-to-one correspondence between the graphic circuit schematic elements and the integrated circuit layout cells;

defining a set of data path rules for governing the combination of data path circuit elements;

combining selected data path circuit elements in compliance with the set of data path rules; and

utilizing the layout files corresponding to the selected data path circuit elements to define an integrated circuit layout for the specific data path schematic diagram.

3. A computer implemented method of designing an integrated circuit data path utilizing a data processing system that includes a central processing unit, a memory for storing graphics information, an input device utilizable for identifying graphics information stored in the memory element, and a display device for displaying graphics information identified by the input device and retrieved from the memory element by the central processing unit, the method comprising:

storing a data path library in the memory element, the data path library including a plurality of graphics element files defining a plurality of graphics functional elements;

storing a layout library in the memory element, the layout library including a plurality of layout files defining a plurality of integrated circuit layout cells, each layout file having a corresponding graphics element file;

storing a set of data path rules in the memory element;

sequentially retrieving selected data path graphics files from the memory element for structured display of the corresponding graphics functional elements on the display device to define a data path schematic diagram;

comparing the data path schematic diagram against the data path rules;

if the data path schematic diagram complies with the data path rules, verifying the timing of the data path structure;

if the timing of the data path schematic diagram is verified, generating a layout of the data path structure utilizing the layout library.

```
┌─────────────────────────┐
│   DATAPATH SCHEMATIC     │
│        CAPTURE           │
└─────────────────────────┘
            │
            ▼
   ╭───────────────────────╮
   │ DATAPATH RULE CHECK    │
   ╰───────────────────────╯
            │
            ▼
┌─────────────────────────┐          ╭───────────────────────╮
│   BLOCK LEVEL TIMING     │◄─────────│    RESYNTHESIZE        │
│  VERIFICATION (CONTROL   │          │   CONTROL LOGIC        │
│      + DATAPATH)         │          ╰───────────────────────╯
└─────────────────────────┘                      ▲
            │                                     │
            ▼                          ╭───────────────────────╮
         ◇─────────◇         N         │      UPDATE            │
       ◇  TIMING OK?  ◇─────────────►  │  CONSTRAINTS FOR       │
         ◇─────────◇                   │   CONTROL LOGIC        │
            │                          ╰───────────────────────╯
            │ Y
            ▼
   ╭───────────────────────╮
   │   LAYOUT GENERATION    │
   ╰───────────────────────╯
```

FIG. 1

FIG. 2

FIG. 3

FIG. 4a

FIG. 4b

FIG. 4c

FIG. 4d

FIG. 4e

FIG. 4f

FIG. 4g

FIG. 4h

FIG. 4i

FIG. 5a

FIG. 5b

en1s

(1Q)

strbot1

nclk
clkbuff

B1

1P    1S

rtb18

B2

## FIG. 5c

en2s

(2Q)

strbot2

nclk
clkbuff

B1

2P

2S    rtb28

B2

## FIG. 5d

en2s    (2Q)

strbot21

en1s    (1Q)

nclk
clkbuff

B1    1P

2P

rtb1b28

B2

## FIG. 5e

FIG. 5f

FIG. 5g

FIG. 5h

FIG. 6a

FIG. 6b

FIG. 6c

FIG. 7a

FIG. 7b

FIG. 7c

FIG. 7d

FIG. 7e

FIG. 7f

FIG. 7g

FIG. 8a

FIG. 8b

nclk | clkbuff | clkxt          B1          b1b2rxt8          B2

FIG. 9a

nclk | clkbuff | clkxt          B1                          b1xt8

FIG. 9b

nclk | clkbuff | clkxt                          b2xt8          B2

FIG. 9c

nclk | clkbuff | clkxt                          rxt8

FIG. 9d

nclk | clkbuff | clkxt          B1                  b1b2xt8          B2

FIG. 9e

nclk | clkbuff | clkxt          B1                  b1rxt8

FIG. 9f

nclk | clkbuff | clkxt                  rb2xt8          B2

FIG. 9g

nclk | clkbuff | clkxt                          spacext

FIG. 9h

EP 0 605 971 A2

FIG. 9i

FIG. 9j

FIG. 10

Fundamental timing criterion: $T_{out} + T_{route} + T_{input} < 1/freq$

For an input: $T_{allowed} = T_{out} + T_{route}$ ; $T_{actual} = 1/freq - T_{input}$

$$\therefore T_{actual} > T_{allowed}$$

For an output: $T_{allowed} = T_{route} + T_{input}$ ; $T_{actual} = 1/freq - T_{output}$

$$\therefore T_{actual} < T_{allowed}$$

FIG. 11

FIG. 12